# EUROPEAN PATENT SPECIFICATION

(11) **EP 4 416 763 B1**
(45) Date of publication and mention of the grant of the patent: **09.04.2025**
(21) Application number: 22839525.7
(22) Date of filing: 10.11.2022
(51) Int. Cl.: H01L 31/043, H01L 31/078, H10K 30/40

(54) **MATERIALS AND METHODS FOR TANDEM PHOTOVOLTAIC DEVICES**
MATERIALIEN UND VERFAHREN FÜR TANDEM-PHOTOVOLTAIKVORRICHTUNGEN
MATÉRIAUX ET PROCÉDÉS POUR DISPOSITIFS PHOTOVOLTAÏQUES EN TANDEM

(30) Priority: 10.11.2021 US 202163277873 P
(43) Date of publication of application: 21.08.2024
(73) Proprietor: First Solar, Inc., Tempe, AZ 85281 (US)
(72) Inventor: KOTARBA, Casimir, Perrysburg, OH 43551 (US); LOS, Andrei, Perrysburg, OH 43551 (US); MUI, Albert, Perrysburg, OH 43551 (US); SCHUMAKER, Alex, Perrysburg, OH 43551 (US)
(74) Representative: Thurston, Joanna
(86) International application number: PCT/US2022/049571
(87) International publication number: WO 2023/086486

(56) References cited:
- US-A- 4 865 918
- US-A1- 2008 236 661
- US-A1- 2011 041 891
- US-A1- 2013 008 499
- US-A1- 2015 059 830
- US-A1- 2015 207 012
- US-A1- 2020 251 082

## Description

### FIELD

The present technology relates to interlayers for photovoltaic devices and, more specifically, to the use of particular layers to improve tandem photovoltaic devices.

### BACKGROUND

A photovoltaic device generates electrical power by converting light into electricity using semiconductor materials that exhibit the photovoltaic effect. Certain semiconductor materials are more efficient at absorbing particular ranges of the electromagnetic spectrum. To improve the overall efficiency of photovoltaic devices, the devices can incorporate stacked submodules, also referred to as subcells, utilizing semiconductor materials with differing absorptive properties to form a tandem photovoltaic device.

In an example tandem photovoltaic device, solar radiation or light enters through a top submodule and a portion of the radiation passes through the top submodule to a bottom submodule. The top submodule can absorb more higher-energy photons having a shorter wavelength, while the bottom submodule can absorb lower energy photons having a longer wavelength. An interlayer can be positioned between the top submodule and the bottom submodule. US2011/041891 and US2015/059830 describe an interlayer suitable for use in tandem photovoltaic devices.

Laboratory experiments measuring absorption efficiency at relevant spectral ranges for separate submodules have shown that there are promising submodules that might be used together to absorb a greater proportion of incident radiation. However, with the increased complexity of a tandem architecture, it can also be challenging to close the gap between actual and theoretical performance. A substantial challenge for producing tandem photovoltaic devices, with good efficiency and manufacturability, is in providing an interlayer having desired electrical, optical, physical, and thermal properties.

Accordingly, a need exists for alternative interlayer structures for use in tandem photovoltaic devices and for processes and materials useful in assembling tandem photovoltaic device architecture.

### SUMMARY

The present invention discloses a tandem photovoltaic device according to claim 1 and a method of making a tandem photovoltaic device according to claim 10.

Tandem photovoltaic devices are provided that can include a first submodule, a second submodule, and an interlayer disposed between the first submodule and the second submodule. The interlayer can permit a portion of light to pass therethrough. The interlayer can include a first conformal layer, a second conformal layer, and a core layer. The first conformal layer can directly contact and conform to a portion of a surface of the first submodule. The first conformal layer can include a first polymer having a melting point less than about 170 degrees C. The second conformal layer can directly contact and conform to a portion of a surface of the second submodule. The second conformal layer can include a second polymer having a melting point less than about 170 degrees C. The core layer can be disposed between and in direct contact with the first conformal layer and the second conformal layer. The core layer can include a third polymer having a melting point greater than about 200 degrees C. Solar radiation or light can hence enter through the first submodule and a portion of the radiation can then pass through the first submodule and the interlayer to the second submodule. The interlayer can maintain a desired dielectric resistance between the first and second submodules. The interlayer can minimize voids or imperfections between surfaces of the first and second submodules to optimize an optical interface therebetween.

Ways of making and using tandem photovoltaic devices are provided that employ the interlayer of the present technology. A portion of a surface of a first submodule can be directly contacted with the first conformal layer. The first conformal layer can then be conformed to the portion of the surface of the first submodule. Likewise, a portion of a surface of a second submodule can be directly contacted with the second conformal layer. The second conformal layer can then be conformed to the portion of the surface of the second submodule. Various ways of contacting and conforming the interlayer with the first and second submodules are provided.

Further areas of applicability will become apparent from the description provided herein. The description and specific examples in this summary are intended for purposes of illustration only and are not intended to limit the scope of the present disclosure.

### DRAWINGS

The drawings described herein are for illustrative purposes only of selected embodiments and not all possible implementations, and are not intended to limit the scope of the present disclosure.
FIG. 1 schematically depicts a cross-sectional view of a tandem photovoltaic device according to one or more embodiments shown and described herein.
FIG. 2 schematically depicts an example submodule of the photovoltaic device of FIG. 1 according to one or more embodiments shown and described herein.
FIG. 3 schematically depicts a cross-sectional view along 3-3 of the photovoltaic submodule of FIG. 2 according to one or more embodiments shown and described herein.
FIG. 4 schematically depicts a substrate according to one or more embodiments shown and described herein.
FIG. 5 schematically depicts a cross-sectional view of the tandem photovoltaic device of FIG. 1 according to one or more embodiments shown and described herein.
FIG. 6 schematically depicts a cross-sectional view of an interlayer stack according to one or more embodiments shown and described herein.
FIG. 7 depicts an example method of making a tandem photovoltaic device according to one or more embodiments shown and described herein.

### DETAILED DESCRIPTION

The following description of technology is merely exemplary in nature of the subject matter, manufacture and use of one or more inventions, and is not intended to limit the scope, application, or uses of any specific invention claimed in this application or in such other applications as may be filed claiming priority to this application, or patents issuing therefrom. Regarding methods disclosed, the order of the steps presented is exemplary in nature, and thus, the order of the steps can be different in various embodiments, including where certain steps can be simultaneously performed, unless expressly stated otherwise. "A" and "an" as used herein indicate "at least one" of the item is present; a plurality of such items may be present, when possible. Except where otherwise expressly indicated, all numerical quantities in this description are to be understood as modified by the word "about" and all geometric and spatial descriptors are to be understood as modified by the word "substantially" in describing the broadest scope of the technology. "About" when applied to numerical values indicates that the calculation or the measurement allows some slight imprecision in the value (with some approach to exactness in the value; approximately or reasonably close to the value; nearly). If, for some reason, the imprecision provided by "about" and/or "substantially" is not otherwise understood in the art with this ordinary meaning, then "about" and/or "substantially" as used herein indicates at least variations that may arise from ordinary methods of measuring or using such parameters.

Unless otherwise specified, values for material properties correspond to conditions at normal temperature and pressure, 20 degrees C and 1 atmosphere pressure.

Unless specified otherwise, values for provided ranges are inclusive of endpoints and include all distinct values and further divided ranges within the entire range.

When an element or layer is referred to as being "on," "engaged to," "connected to," or "coupled to" another element or layer, it may be directly on, engaged, connected, or coupled to the other element or layer, or intervening elements or layers may be present. In contrast, when an element is referred to as being "directly on," "directly engaged to," "directly connected to" or "directly coupled to" another element or layer, there may be no intervening elements or layers present. Other words used to describe the relationship between elements should be interpreted in a like fashion (e.g., "between" versus "directly between," "adjacent" versus "directly adjacent," etc.). As used herein, the term "and/or" includes any and all combinations of one or more of the associated listed items.

Although the terms first, second, third, etc. may be used herein to describe various elements, components, regions, layers and/or sections, these elements, components, regions, layers and/or sections should not be limited by these terms. These terms may be only used to distinguish one element, component, region, layer or section from another region, layer, or section. Terms such as "first," "second," and other numerical terms when used herein do not imply a sequence or order unless clearly indicated by the context. Thus, a first element, component, region, layer, or section discussed below could be termed a second element, component, region, layer, or section without departing from the teachings of the example embodiments.

Spatially relative terms, such as "inner," "outer," "beneath," "below," "lower," "above," "upper," and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. The device may be otherwise oriented (rotated 90 degrees or at other orientations) and the spatially relative descriptors used herein interpreted accordingly.

The term "light" can refer to various wavelengths of the electromagnetic spectrum such as, but not limited to, wavelengths in the ultraviolet (UV), infrared (IR), and visible portions of the electromagnetic spectrum. "Sunlight," as used herein, refers to light emitted by the sun. As used herein, near-infrared (NIR) refers to wavelengths in a range of about 700 nm to 1300 nm.

The term "layer" can refer to a thickness of material provided upon a surface. The layer can cover all or a portion of the surface. A layer may include sublayers and can have compositional gradients within a layer. A layer can include one or more functional layers of material.

The present technology relates to tandem photovoltaic devices that include a first submodule and a second submodule; however, it should be recognized that such tandem photovoltaic devices can include additional submodules as well as additional arrangements of submodules. In construction of the tandem photovoltaic devices, as provided herein, an interlayer is disposed between the first submodule and the second submodule, where the interlayer permits a portion of light to pass therethrough. In this way, a portion of light passing through the first submodule can further pass through the interlayer to the second submodule. The interlayer can be transparent to near-infrared wavelengths of light. Near-infrared light, incident on the front surface of the tandem device, can pass through the first submodule and interlayer for absorption in the second submodule. The interlayer can operate to maintain a desired dielectric resistance between the first and second submodules. The interlayer can further minimize voids or imperfections between surfaces of the first and second submodules to optimize an optical interface therebetween.

The tandem photovoltaic device can generate electrical power by converting light into direct current electricity using semiconductor materials that exhibit the photovoltaic effect. The photovoltaic effect generates electrical power upon exposure to light as photons are absorbed within the semiconductor material to excite electrons to a higher energy state. These excited electrons can move within the material, resulting in an electrical current. Semiconductor materials suitable for use in photovoltaic devices can include, for example, type II-VI materials - including cadmium telluride alloys, type III-V materials - including GaAs and InGaN, type I-III-VI materials - including CIGS and CIS materials, as well as silicon, and perovskites.

Tandem photovoltaic devices can achieve higher total conversion efficiency than single photovoltaic devices by capturing a larger portion of the solar spectrum. Tandem devices can be formed with more than one p-n junction and with materials having different band-gap properties responsive to different ranges of the electromagnetic spectrum, including infrared, visible, and ultraviolet light. In a device for which the primary light source is from above, a light-incident top cell, or upper submodule, can have a large band gap to capture energetic short wavelengths, such as visible and uv, while a bottom cell, or lower submodule, can use absorber materials having a smaller band gap to capture longer wavelengths and reflected photons, including near-infrared. A tandem device can have two or more stacked sub-cells or submodules, and each submodule can include active regions formed from semiconductor materials having different absorptive properties, including different types of semiconductor materials.

Submodules in a tandem photovoltaic device, as described herein, can be stacked and separated by the interlayer. Incident electromagnetic radiation, or light, enters the device through a front or top surface and enters the upper submodule. Light that is not absorbed by the upper submodule, reaches the interlayer. The interlayer can be configured to reflect some light energy, or photons, back into the upper submodule, and also transmit photons of the light to the back cell or lower submodule. In most tandem devices, it is beneficial for interlayer structures to be substantially transparent to spectral radiation wavelengths configured to be absorbed by the lower submodule. In photovoltaic devices having a plurality of stacked submodules, additional interlayers can be provided between each submodule. Tandem photovoltaic devices can include bifacial devices, configured to receive incident radiation through both front and rear surfaces. Bifacial tandem devices can be configured to receive direct solar radiation on a top or front surface and receive radiation reflected from external surfaces, including visible and infrared light, on a back or rear surface.

Interlayer structures can be exposed to stresses including high temperatures, ultraviolet radiation, mechanical stresses, and temperature fluctuations. Undesirably, in certain photovoltaic devices, these stresses can cause shorting between submodules across an interlayer, and can result in damage to the photovoltaic device. To prevent shorting, it is desirable for interlayer structures to have a suitable dielectric breakthrough strength to electrically separate the first and second submodules. To design efficient and reliable tandem photovoltaic devices, it is also desirable to prevent gaps or bubbles between the interlayer structure and bordering surfaces of the first and second submodules. In some tandem architectures, it can be desirable for the interlayer to have a refractive index suitable to transmit photons to the second submodule and/or reflect some photons back into the first submodule.

In a tandem photovoltaic module, the risk of shorting from one active surface of one submodule to an active surface of the other submodule is important. Electrical isolation between the active surfaces of the submodules maintains a minimum dielectric breakdown distance. At the same time, to make good contact for light transmission and to protect submodules from degradation, an encapsulant can be formed between the first and second submodules and around other system components. An interlayer structure that can both isolate and encapsulate surfaces of adjacent submodules is desirable. To achieve the desired properties, a method and structure is provided for an interlayer formed of a multilayered film having outer layers which provide the desired adhesion and encapsulation and a central core layer which maintains the desired dielectric and structural properties.

In certain embodiments, an interlayer is provided that includes a plurality of layers. The interlayer includes one or more core layers that each can have a high dielectric strength and be non-flowable at expected operating conditions of the tandem photovoltaic device, where the material of each core layer can have a high melting point. The interlayer structure includes an outer layer or a first conformal layer that is flowable with a low melting point. The interlayer structure can also include another outer layer or a second conformal layer, with the first and second conformal layers positioned on opposite sides of the core layer. The conformal layers can include layers of flowable polymer with a melting point less than 170 degrees C to conform to system components during lamination and operation at higher temperatures. The core layer comprises a non-flowable polymeric material with a melting point greater than 200 degrees C to sustain a dielectric and physical barrier that resists deformation and a narrowing of the dielectric breakdown distance. The interlayer structure, comprising a multi-layered film, provides dielectric resistance across a wide operating temperature range. The interlayer can therefore be configured as a transparent multilayered film for mechanically stacked multijunction solar cells that provides transparency, thermal stability, adhesive strength, moisture protection, prevents shorting, and maintains minimum dielectric breakdown distance between submodules separated by the interlayer. The interlayer can also prevent moisture permeation and can be used to or cooperate with other portions of the tandem photovoltaic device to electrically connect different system components.

Tandem photovoltaic devices constructed in accordance with the present technology can include a first submodule, a second submodule, and an interlayer disposed between the first submodule and the second submodule. The interlayer can permit a portion of light to pass therethrough. The interlayer can include a first conformal layer, a second conformal layer, and a core layer. The first conformal layer can directly contact and conform to a portion of a surface of the first submodule, where the first conformal layer includes a first polymer having a melting point less than about 170 degrees C. The second conformal layer direct contacts and conforms to a portion of a surface of the second submodule, where the second conformal layer includes a second polymer having a melting point less than about 170 degrees C. The core layer is disposed between and directly contacts the first conformal layer and the second conformal layer, where the core layer includes a third polymer having a melting point greater than about 200 degrees C. In certain embodiments, the third polymer can have a melting point greater than about 250 degrees C.

Interlayers, as provided herein, can include various aspects. For example, the interlayer can have a refractive index from about 1.2 to about 2.0. In some embodiments, the interlayer has a refractive index greater than 1.4, greater than 1.5, greater than 1.6, or greater than 1.7. In some embodiments, the interlayer has a refractive index in a range of 1.5 to 1.8, a range of 1.6 to 1.8, a range of 1.7 to 1.9, or a range of 1.6 to 1.7, for wavelengths in a range of 800 nm to 1200 nm. Certain embodiments include where the interlayer has a refractive index of about 1.6. Still further embodiments include where the interlayer has a refractive index of greater than about 1.6. In this way, the interlayer can provide an optical interface allowing effective transmission of light passing through one submodule to another submodule. The interlayer can also exhibit a dielectric strength greater than 10 kV/mm. The opportunity for any electrical shorting between submodules is therefore minimized. Embodiments of the interlayer can have a thickness from about 100 µm to about 1500 µm, which can include the total thickness of the first and second conformal layers and the core layer. The interlayer can permit a portion of near-infrared light to pass therethrough. The interlayer can be configured to transmit at least 85% of light having a wavelength from 700 nm to 1300 nm. The interlayer can be configured to transmit at least 90% of light having a wavelength from about 800 nm to about 1200 nm. In some embodiments, the interlayer can permit a portion of visible light to pass therethrough. The interlayer can be further configured to transmit at least 90% of light having a wavelength from about 400 nm to about 800 nm that passes therethrough. Certain embodiments of the interlayer can have a light transmission of at least 85% for wavelengths from 750 nm to 1200 nm. Still further embodiments of the interlayer can have a light transmission of at least 90% at 800 nm.

Polymers used in forming the first and second conformal layers and core layer of the interlayer can include various aspects. The first polymer and the second polymer of the respective first and second conformal layers can independently include one or more of: polyethylene; ethylene-vinyl acetate; polyolefin elastomer (POE); pressure sensitive adhesive; hot-melt adhesive; polyvinyl butyral; thermoplastic polyurethane; silicone; silicone/polyurethane hybrid; ionomer; UV-curable resin; ethylene tetrafluoroethylene (e.g., Tefzel), polyvinyl fluoride (e.g., Tedlar), fluoroplastic of tetrafluoroethylene, hexafluoropropylene, and vinylidene fluoride (e.g., THV220); and polyethylene naphthalate. Certain embodiments include where the first polymer and the second polymer comprise the same material. The third polymer of the core layer can include one or more of oriented polyethylene terephthalate, polytetrafluoroethylene, polycyclooctene, biaxially-oriented polyethylene terephthalate (boPET), and polyimide.

Various layers of the interlayer can have various thicknesses. The first conformal layer and the second conformal layer can have different thicknesses. The conformal layers can operate as adhesives as well as encapsulants. When the polymers of the conformal layers are substantially at their respective melting points, the conformal layers can flow and spread across portions of the surfaces of the respective submodules.

The core layer can include various aspects. The core layer can have a thickness from about 25 µm to about 500 µm. Embodiments of the core layer can also have a dielectric strength greater than about 50 kV/mm. The one or more polymers of the core layer can be selected to have melting points above the expected operating temperature of the tandem photovoltaic device. In this way, integrity of the core layer can be maintained during operation of the tandem photovoltaic device, including where the core layer maintains a desired thickness and provides a desired dielectric strength between submodules during operation of the tandem photovoltaic device.

Certain embodiments of the interlayer can include where the first and second conformal layers have thicknesses of 300 µm, the core layer has a thickness of 100 µm, and the third polymer of the core layer includes biaxially-oriented polyethylene terephthalate.

Certain embodiments of the tandem photovoltaic device include a first submodule, a second submodule, and an interlayer disposed between the first submodule and the second submodule. The interlayer is configured to permit a portion of light to pass therethrough, have a refractive index from about 1.2 to about 2.0, a dielectric strength greater than about 10 kV/mm, and a thickness from about 100 µm to about 1500 µm. The interlayer includes a first conformal layer, a second conformal layer, and a core layer. The first conformal layer directly contacts and conforms to a portion of a surface of the first submodule, where the first conformal layer includes a first polymer having a melting point less than about 170 degrees C, and the first polymer includes a member selected from a group consisting of: polyethylene; ethylene-vinyl acetate; polyolefin elastomer; and combinations thereof. The second conformal layer directly contacts and conforms to a portion of a surface of the second submodule, where the second conformal layer includes a second polymer having a melting point less than about 170 degrees C, and the second polymer includes a member selected from a group consisting of: polyethylene; ethylene-vinyl acetate; polyolefin elastomer; and combinations thereof. The core layer is disposed between and directly contacts the first conformal layer and the second conformal layer, where the core layer has a dielectric strength greater than about 50 kV/mm and includes a third polymer having a melting point greater than about 200 degrees C. The third polymer includes a member selected from a group consisting of: polyethylene terephthalate (PET), oriented polyethylene terephthalate; polytetrafluoroethylene; polycyclooctene; biaxially-oriented polyethylene terephthalate; polyimide; and combinations thereof.

The present technology further provides various methods of making a tandem photovoltaic device. Such methods include providing an interlayer as described herein. A portion of a surface of a first submodule can be directly contacted with the first conformal layer of the interlayer. The first conformal layer can be conformed to the portion of the surface of the first submodule. A portion of a surface of a second submodule can be directly contacted with the second conformal layer of the interlayer. The second conformal layer can be conformed to the portion of the surface of the second submodule. In this way, the core layer can electrically connect two submodules, in certain embodiments, along with preventing moisture ingress into the tandem photovoltaic device.

Provision of the interlayer can take various forms. Certain embodiments include where the core layer is laminated between the first conformal layer and the second conformal layer to provide the interlayer. Likewise, the core layer can be extruded between the first conformal layer and the second conformal layer to provide the interlayer. Other means by which to form the interlayer include hot melt, deposition of one or more layers, and coextrusion of more than one layer thereof.

The methods of making tandem photovoltaic devices can include various aspects. Conforming the first conformal layer to the portion of the surface of the first submodule can include heating the first conformal layer to at least the melting point of the first polymer. Conforming the second conformal layer to the portion of the surface of the second submodule can also include heating the second conformal layer to at least the melting point of the second polymer. It is also possible that one of the portion of the surface of the first submodule and the first conformal layer can be heated to at least the melting point of the first polymer prior to directly contacting the portion of the surface of the first submodule with the first conformal layer, and one of the portion of the surface of the second submodule and the second conformal layer can be heated to at least the melting point of the second polymer prior to directly contacting the portion of the surface of the second submodule with the second conformal layer.

Certain methods can include where conforming the first conformal layer to the portion of the surface of the first submodule and conforming the first conformal layer to the portion of the surface of the first submodule can include simultaneously heating the first submodule, the interlayer, and the second submodule to at least the melting point of the first polymer and at least the melting point of the second polymer following directly contacting the portion of the surface of the first submodule with the first conformal layer and directly contacting the portion of the surface of the second submodule with the second conformal layer. It is also possible to have conforming of the first conformal layer to the portion of the surface of the first submodule to include pressing the interlayer and the first submodule together, or to have conforming the second conformal layer to the portion of the surface of the second submodule to include pressing the interlayer and the second submodule together. Embodiment of methods can further include where conforming the first conformal layer to the portion of the surface of the first submodule and conforming the first conformal layer to the portion of the surface of the first submodule include pressing the interlayer between the first submodule and the second submodule.

In certain embodiments, a precursor to the interlayer can be formed as a contiguous sheet having a plurality of layers including a core layer disposed between a first conformal layer and second conformal layer. The precursor can be placed between a first submodule and a second submodule to form an unbonded tandem photovoltaic device. The unbonded tandem photovoltaic device is subjected to a lamination heat treatment sufficient for the first conformal layer and second conformal layer to flow and bond with the respective adjacent submodules and form a bonded tandem photovoltaic device. At least portions of the respective conformal layers melt during lamination to achieve desired wettability and adhesion of the interlayer to the respective submodules, while the core layer does not melt during lamination and maintains a physical and electrical barrier between the submodules. After the lamination, the interlayer physically and electrically isolates the active surfaces of the submodules in the tandem photovoltaic device. The bonded tandem photovoltaic device can be subjected to finishing processing steps, such as adding further encapsulation layers, bussing, etc. to produce a finished tandem photovoltaic device.

Aspects of the present technology can apply in various combinations, interdependencies, and multiple dependencies, as set forth in the following instances, examples, and embodiments.

In an embodiment, a tandem photovoltaic device comprises a first submodule; a second submodule; and an interlayer disposed between the first submodule and the second submodule, wherein the interlayer permits a portion of light to pass therethrough, the interlayer including: a first conformal layer directly contacting and conforming to a portion of a surface of the first submodule, the first conformal layer including a first polymer having a melting point less than about 100 degrees C; a second conformal layer directly contacting and conforming to a portion of a surface of the second submodule, the second conformal layer including a second polymer having a melting point less than about 100 degrees C; a core layer disposed between and directly contacting the first conformal layer and the second conformal layer, the core layer including a third polymer having a melting point greater than about 200 degrees C.

In some instances, the interlayer has a refractive index from about 1.2 to about 2.0.

In some instances, the interlayer has a dielectric strength greater than about 10 kV/mm.

In some instances, the interlayer has a thickness from about 400 µm to about 1500 µm.

In some instances, the interlayer is configured to transmit at least 90% of incident light having a wavelength from 800 nm to 1200 nm.

In the invention, the first polymer and the second polymer independently include a member selected from a group consisting of: polyethylene; ethylene-vinyl acetate; polyolefin elastomer; and combinations thereof. In some instances, the first polymer consists essentially of polyolefin elastomer.

In some instances, the first polymer and the second polymer comprise the same material. In some instances, the first polymer and the second polymer consist essentially of, or consist of, the same material.

In the invention, the third polymer includes a member selected from a group consisting of: polyethylene terephthalate, oriented polyethylene terephthalate; polytetrafluoroethylene; polycyclooctene; biaxially-oriented polyethylene terephthalate; polyimide; and combinations thereof. In some instances, the core layer consists essentially of polyethylene terephthalate.

In some instances, the core layer has a thickness from 25 µm to 200 µm.

In some instances, the core layer has a dielectric strength greater than 50 kV/mm.

In some instances, the first conformal layer and the second conformal layer have different thicknesses.

In some instances, the first conformal layer has a thickness of about 300 µm, the second conformal layer has a thicknesses of 300 µm, the core layer has a thickness of 100 µm, and the third polymer of the core layer includes biaxially-oriented polyethylene terephthalate.

According to the embodiments provided herein, a tandem photovoltaic device can include a first submodule; a second submodule; an interlayer disposed between the first submodule and the second submodule, wherein the interlayer permits a portion of light to pass therethrough, has a refractive index from about 1.2 to about 2.0, a dielectric strength greater than about 10 kV/mm, a thickness from about 400 µm to about 1500 µm, the interlayer including: a first conformal layer directly contacting and conforming to a portion of a surface of the first submodule, the first conformal layer including a first polymer having a melting point less than about 170 degrees C, wherein the first polymer includes a member selected from a group consisting of: polyethylene; ethylene-vinyl acetate; polyolefin elastomer; and combinations thereof; a second conformal layer directly contacting and conforming to a portion of a surface of the second submodule, the second conformal layer including a second polymer having a melting point less than about 170 degrees C, wherein the second polymer includes a member selected from a group consisting of: polyethylene; ethylene-vinyl acetate; polyolefin elastomer; and combinations thereof; a core layer disposed between and directly contacting the first conformal layer and the second conformal layer, the core layer having a dielectric strength greater than about 50 kV/mm, the core layer including a third polymer having a melting point greater than about 200 degrees C, wherein the third polymer includes a member selected from a group consisting of: oriented polyethylene terephthalate; polytetrafluoroethylene; polycyclooctene; biaxially-oriented polyethylene terephthalate; polyimide; and combinations thereof.

According to the embodiments of the present disclosure, a method of making a tandem photovoltaic device, can include: providing an interlayer, wherein the interlayer permits a portion of light to pass therethrough, the interlayer including: a first conformal layer including a first polymer having a melting point less than about 170 degrees C; a second conformal layer including a second polymer having a melting point less than about 170 degrees C; a core layer disposed between and directly contacting the first conformal layer and the second conformal layer, the core layer including a third polymer having a melting point greater than about 200 degrees C; directly contacting a portion of a surface of a first submodule with the first conformal layer; conforming the first conformal layer to the portion of the surface of the first submodule; directly contacting a portion of a surface of a second submodule with the second conformal layer; and conforming the second conformal layer to the portion of the surface of the second submodule.

In some instances, the method further comprises laminating the core layer between the first conformal layer and the second conformal layer to provide the interlayer.

In some instances, the method further comprises coextruding the core layer between the first conformal layer and the second conformal layer to provide the interlayer.

In some instances, the step of conforming the first conformal layer to the portion of the surface of the first submodule includes heating the first conformal layer to at least the melting point of the first polymer. In some instances, the step of conforming the second conformal layer to the portion of the surface of the second submodule includes heating the second conformal layer to at least the melting point of the second polymer.

In some embodiments, one of the portion of the surface of the first submodule and the first conformal layer is heated to at least the melting point of the first polymer prior to directly contacting the portion of the surface of the first submodule with the first conformal layer; and one of the portion of the surface of the second submodule and the second conformal layer is heated to at least the melting point of the second polymer prior to directly contacting the portion of the surface of the second submodule with the second conformal layer.

In some embodiments, methods can include conforming the first conformal layer to the portion of the surface of the first submodule and conforming the second conformal layer to the portion of the surface of the second submodule, and simultaneously heating the first submodule, the interlayer, and the second submodule to at least the melting point of the first polymer and at least the melting point of the second polymer following directly contacting the portion of the surface of the first submodule with the first conformal layer and directly contacting the portion of the surface of the second submodule with the second conformal layer.

In some embodiments, methods can include conforming the first conformal layer to the portion of the surface of the first submodule includes pressing the interlayer and the first submodule together; or conforming the second conformal layer to the portion of the surface of the second submodule includes pressing the interlayer and the second submodule together.

In some embodiments, methods can include conforming the first conformal layer to the portion of the surface of the first submodule and conforming the second conformal layer to the portion of the surface of the second submodule include pressing the interlayer between the first submodule and the second submodule.

### EXAMPLES

Example embodiments of the present technology are provided with reference to the several figures enclosed herewith.

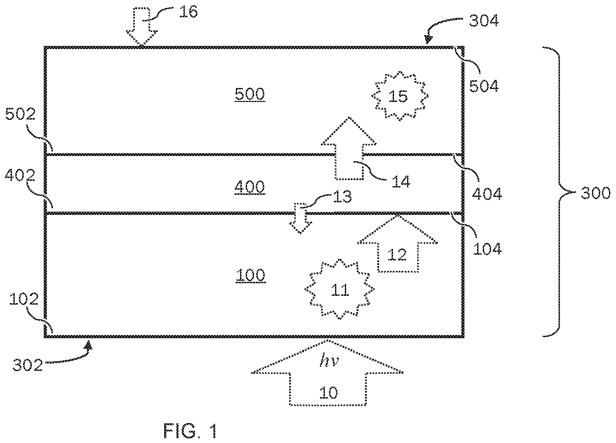

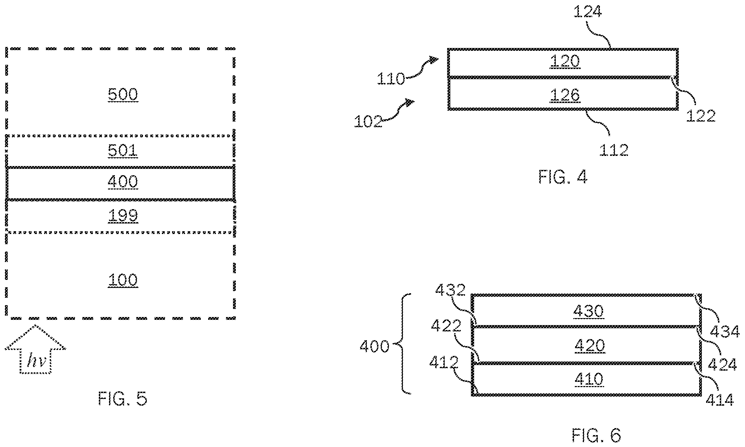

With reference to FIGS. 1 & 5, an embodiment of a tandem photovoltaic device 300 is shown. The tandem photovoltaic device 300 can be configured to receive light and transform light into electrical energy, as photons are absorbed from the light and transformed into electrical current via the photovoltaic effect. For sake of discussion and clarity, the tandem photovoltaic device 300 can define a front side 302 configured to face a primary light source such as, for example, the sun. Additionally, the tandem photovoltaic device 300 can also define a back side 304 offset from the front side 302 such as, for example, by a plurality of functional layers of material.

The tandem photovoltaic device 300 can have a first submodule 100, a second submodule 500, and an interlayer 400 therebetween. The first submodule 100 can also be termed a top cell or upper submodule. The second submodule 500 can also be termed a bottom cell or lower submodule. The interlayer 400, can also be termed an interlayer stack, a dielectric stack, or a transparent coupling layer. Each of the first submodule 100, the second submodule 500, and the interlayer 400 can comprise a plurality of layers. Each of the first and second submodules 100, 500 of the tandem photovoltaic device 300 can include one or more absorber layers for converting light into charge carriers, and conductive layers for collecting the charge carriers.

The first submodule 100 can have a first surface 102 substantially facing the front side 302 of the tandem photovoltaic device 300 and a second surface 104 substantially facing the back side 304 of the photovoltaic device 300. The interlayer 400 can have a first surface 402 substantially facing the front side 302 of the photovoltaic device 300 and a second surface 404 substantially facing the back side 304 of the photovoltaic device 300. The second submodule 500 can have a first surface 502 substantially facing the front side 302 of the photovoltaic device 300 and a second surface 504 substantially facing the back side 304 of the photovoltaic device 300.

As depicted in FIG. 1, incident light *(hv)* 10 can enter the front side 302 of the tandem photovoltaic device 300 through the first submodule 100 and a first portion 11 of light energy can be absorbed by the first submodule 100 and a remaining portion 12 of light energy can pass through the first submodule 100 to the interlayer 400. At the interlayer 400, reflected light 13 can be directed back toward the absorptive region of the first submodule 100 and transmitted light 14 can pass to the second submodule 500. Optionally, in a bifacial tandem device, back side light energy 16 can enter the back side 304 of the tandem photovoltaic device 300 toward the second submodule 500. In many implementations, back side light energy 16 can include externally reflected visible light and near infrared light. The first submodule can absorb the first portion 11 of light energy, which can include an absorbed combination of the incident light 10 and the reflected light 13. The second submodule can absorb a second portion 15 of light energy comprising the transmitted light 14 and, optionally, the back side light energy 16.

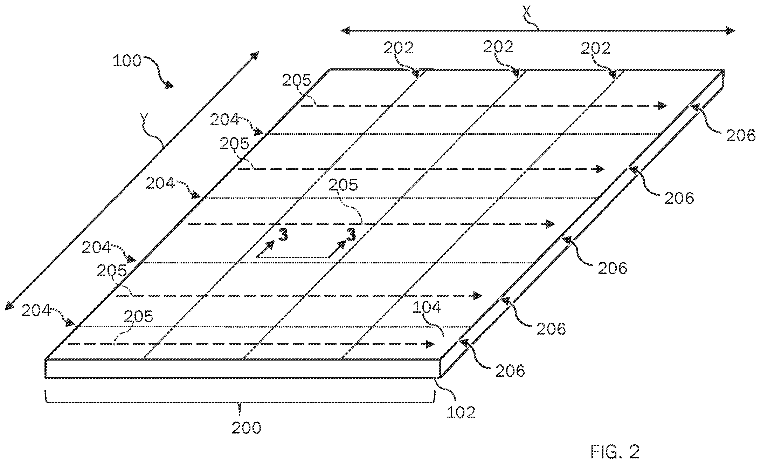

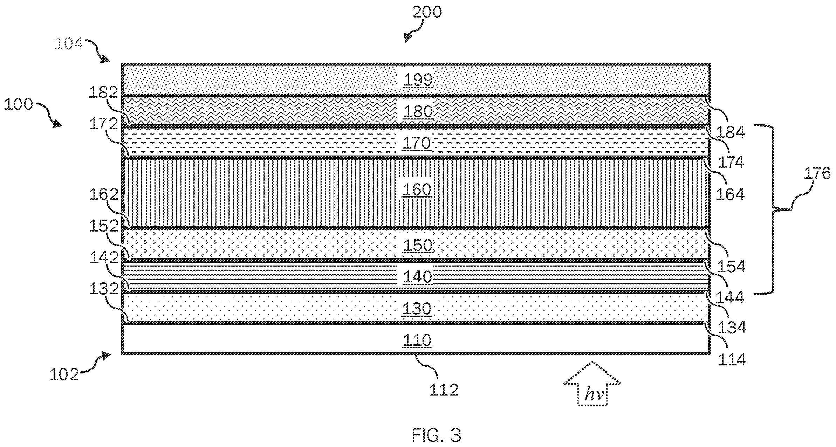

Referring now to FIGS. 2 & 3, an example embodiment of the first submodule 100 of the tandem photovoltaic device 300 is shown. The first submodule 100 can include a plurality of layers disposed between the front side 102 and the back side 104. In some embodiments, the layers of the first submodule 100 can be divided into an array of photovoltaic cells 200. For example, the first submodule 100 can be scribed according to a plurality of serial scribes 202 and a plurality of parallel scribes 204. The serial scribes 202 can extend along a length Y of the first submodule 100 and demarcate the photovoltaic cells 200 along the length Y of the first submodule 100. Neighboring cells of the photovoltaic cells 200 can be serially connected along a width X of the first submodule 100. In other words, a monolithic interconnect of the neighboring cells 200 can be formed; e.g., adjacent to the serial scribe 202. The parallel scribes 204 can extend along the width X of the first submodule 100 and demarcate the photovoltaic cells 200 along the width X of the first submodule 100. Under operation, current 205 can predominantly flow along the width X through the photovoltaic cells 200 serially connected by the serial scribes 202. Under operation, parallel scribes 204 can limit the ability of current 205 to flow along the length Y. Parallel scribes 204 are optional and can be configured to separate the photovoltaic cells 200 that are connected serially into groups 206 arranged along length Y.

With particular reference to FIG. 2, the parallel scribes 204 can electrically isolate the groups 206 of photovoltaic cells 200 that are serially connected. In some embodiments, the groups 206 of the photovoltaic cells 200 can be connected in parallel such as, for example, via electrical bussing. Optionally, the number of parallel scribes 204 can be configured to limit a maximum current generated by each group 206 of the photovoltaic cells 200. In some embodiments, the maximum current generated by each group 206 can be less than or equal to about 200 milliamps (mA) such as, for example, less than or equal to about 100 mA in one embodiment, less than or equal to about 75 mA in another embodiment, or less than or equal to about 50 mA in a further embodiment.

With particular reference to FIG. 3, the layers of the first submodule 100 can include a thin film stack provided over a substrate 110. The substrate 110 can be configured to facilitate the transmission of light into the first submodule 100. The substrate 110 can be disposed at the front side 102 of the first submodule 100. Referring collectively to FIGS. 2 & 3, the substrate 110 can have a first surface 112 substantially facing the front side 102 of the first submodule 100 and a second surface 114 substantially facing the back side 104 of the first submodule 100. One or more layers of material can be disposed between the first surface 112 and the second surface 114 of the substrate 110.

Referring now to FIG. 4, the substrate 110 can include a transparent layer 120 having a first surface 122 substantially facing the front side 102 of the first submodule 100 and a second surface 124 substantially facing the back side 104 of the first submodule 100. In some embodiments, the second surface 124 of the transparent layer 120 can form the second surface 114 of the substrate 110. The transparent layer 120 can be formed from a substantially transparent material such as, for example, glass. Suitable glass can include soda-lime glass, or any glass with reduced iron content. The transparent layer 120 can have any suitable transmittance range, including about 250 nm to about 1,300 nm, in some embodiments. The transparent layer 120 can also have any suitable transmittance percentage, including, for example, more than about 50% in one embodiment, more than about 60% in another embodiment, more than about 70% in yet another embodiment, more than about 80% in a further embodiment, or more than about 85% in still a further embodiment. In one embodiment, transparent layer 120 can be formed from a glass with about 90% transmittance, or more. Optionally, the substrate 110 can include a coating 126 applied to the first surface 122 of the transparent layer 120. The coating 126 can be configured to interact with light or to improve durability of the substrate 110 such as, but not limited to, an antireflective coating, an antifouling coating, or a combination thereof.

Referring again to FIG. 3, the first submodule 100 can include a barrier layer 130 configured to mitigate diffusion of contaminants from the substrate 110, which could result in degradation or delamination of other layers of the photovoltaic stack. The barrier layer 130 can have a first surface 132 substantially facing the front side 102 of the first submodule 100 and a second surface 134 substantially facing the back side 104 of the first submodule 100. In some embodiments, the barrier layer 130 can be provided adjacent to the substrate 110. For example, the first surface 132 of the barrier layer 130 can be provided upon the second surface 114 of the substrate 110.

Generally, the barrier layer 130 can be substantially transparent, thermally stable, with a reduced number of pin holes, have high sodium-blocking capability, and good adhesive properties. Alternatively, or additionally, the barrier layer 130 can be configured to apply color suppression to light. The barrier layer 130 can include one or more layers of suitable material, including, but not limited to, tin oxide, silicon dioxide, aluminum-doped silicon oxide, silicon oxide, silicon nitride, or aluminum oxide. The barrier layer 130 can have any suitable thickness bounded by the first surface 132 and the second surface 134, including, for example, more than about 10 nanometers in one embodiment, more than about 15 nm in another embodiment, or less than about 20 nm in a further embodiment.

With continuing reference to FIG. 3, the first submodule 100 can include a transparent conductive oxide (TCO) layer 140 configured to provide electrical contact to transport charge carriers generated by the first submodule 100. The TCO layer 140 can have a first surface 142 substantially facing the front side 102 of the first submodule 100 and a second surface 144 substantially facing the back side 104 of the first submodule 100. In some embodiments, the TCO layer 140 can be provided adjacent to the barrier layer 130. For example, the first surface 142 of the TCO layer 140 can be provided upon the second surface 134 of the barrier layer 130. Generally, the TCO layer 140 can be formed from one or more layers of n-type semiconductor material that is substantially transparent and has a wide band gap. Specifically, the wide band gap can have a larger energy value compared to the energy of the photons of the light, which can mitigate undesired absorption of light. The TCO layer 140 can include one or more layers of suitable material, including, but not limited to, tin dioxide, doped tin dioxide (e.g., F-SnO₂), indium tin oxide, or cadmium tin oxide (Cd₂SnO₄). In embodiments where the TCO layer 140 comprises cadmium stannate, the cadmium stannate can be provided in a crystalline form. For example, the cadmium stannate can be deposited as a film and then subjected to an annealing process, which transforms the thin film into a crystallized film.

The first submodule 100 can include a buffer layer 150 configured to provide an insulating layer between the TCO layer 140 and any adjacent semiconductor layers. The buffer layer 150 can have a first surface 152 substantially facing the front side 102 of the first submodule 100 and a second surface 154 substantially facing the back side 104 of the first submodule 100. In some embodiments, the buffer layer 150 can be provided adjacent to the TCO layer 140. For example, the first surface 152 of the buffer layer 150 can be provided upon the second surface 144 of the TCO layer 140. The buffer layer 150 can include material having higher resistivity than the TCO later 140, including, but not limited to, intrinsic tin dioxide, zinc magnesium oxide (e.g., Znₗ₋ₓMgₓO), silicon dioxide (SiO₂), aluminum oxide (Al₂O₃), aluminum nitride (AlN), zinc tin oxide, zinc oxide, tin silicon oxide, or any combination thereof. In some embodiments, the material of the buffer layer 150 can be configured to substantially match the band gap of an adjacent semiconductor layer (e.g., an absorber). The buffer layer 150 can have a suitable thickness between the first surface 152 and the second surface 154, including, for example, more than about 10 nm in one embodiment, between about 10 nm and about 80 nm in another embodiment, or between about 15 nm and about 60 nm in a further embodiment.

Referring still to FIG. 3, the first submodule 100 can include an absorber layer 160 configured to cooperate with another layer and form a p-n junction within the first submodule 100. Accordingly, absorbed photons of the light can free electron-hole pairs and generate carrier flow, which can yield electrical energy. The absorber layer 160 can have a first surface 162 substantially facing the front side 102 of the first submodule 100 and a second surface 164 substantially facing the back side 104 of the first submodule 100. A thickness of the absorber layer 160 can be defined between the first surface 162 and the second surface 164. The thickness of the absorber layer 160 can be between about 0.5 µm to about 10 µm such as, for example, between about 1 µm to about 7 µm in one embodiment, or between about 1.5 µm to about 4 µm in another embodiment.

The absorber layer 160 can be formed from a p-type semiconductor material having an excess of positive charge carriers, i.e., holes or acceptors. In an example, the absorber layer 160 can comprise a Group I-III-VI absorber material, such as, for example, copper indium gallium sulfide/selenide (CIGS), copper gallium sulfide/selenide (CGS), or CuInSe₂ (CIS), and can be provided as a thin film. The absorber layer 160 can include a suitable p-type semiconductor material such as Group II-VI semiconductors, for example, cadmium and tellurium (CdTe) or cadmium selenide (CdSe). Further examples of Group II-VI absorber materials include, but are not limited to, semiconductor materials comprising cadmium, zinc, tellurium, selenium, or any combination thereof. In some embodiments, the absorber layer 160 can include ternaries of cadmium, selenium, and tellurium (e.g., CdSeₓTe₁₋ₓ), or a compound comprising cadmium, selenium, tellurium, and one or more additional element (e.g., CdZnSeTe). The absorber layer 160 can further include one or more dopants. The first submodule 100 provided herein can include a plurality of absorber materials.

In embodiments where the absorber layer 160 comprises tellurium and cadmium, the average atomic percent of the tellurium in the absorber layer 160 can be greater than or equal to about 25 atomic percent and less than or equal to about 50 atomic percent such as, for example, greater than about 30 atomic percent and less than about 50 atomic percent in one embodiment, greater than about 40 atomic percent and less than about 50 atomic percent in a further embodiment, or greater than about 47 atomic percent and less than about 50 atomic percent in yet another embodiment. Alternatively, or additionally, average atomic percent of the tellurium in the absorber layer 160 can be greater than about 45 atomic percent such as, for example, greater than about 49 atomic percent in one embodiment. It is noted that the average atomic percent described herein is representative of the entirety of the absorber layer 160, the atomic percentage of material at a particular location within the absorber layer 160 can be graded through the thickness compared to the overall composition of the absorber layer 160. For example, the absorber layer 160 can have a graded composition.

In embodiments where the absorber layer 160 comprises selenium and tellurium, the average atomic percent of the selenium in the absorber layer 160 can be greater than 0 atomic percent and less than or equal to about 25 atomic percent such as, for example, greater than about 1 atomic percent and less than about 20 atomic percent in one embodiment, greater than about 1 atomic percent and less than about 15 atomic percent in another embodiment, or greater than about 1 atomic percent and less than about 8 atomic percent in a further embodiment. It is noted that the concentration of tellurium, selenium, or both can be graded through the thickness of the absorber layer 160. For example, when the absorber layer 160 includes a compound including selenium at a mole fraction of x and tellurium at a mole fraction of 1-x (SeₓTe₁₋ₓ), x can vary in the absorber layer 160 with distance from the first surface 162 of the absorber layer 160.

Referring still to FIG. 3, the absorber layer 160 can be doped with a dopant configured to manipulate the charge carrier concentration. In some embodiments, the absorber layer 160 can be doped with a Group VA (group 15) dopant such as, for example, arsenic, phosphorous, antimony, or a combination thereof. Alternatively, or additionally, the absorber layer 160 can be doped with a Group IB (group 11) dopant such as, for example, copper, silver, gold, or a combination thereof. The total density of the dopant within the absorber layer 160 can be controlled. Moreover, the amount of the dopant can vary with distance from the first surface 162 of the absorber layer 160.

FIG. 3 shows an example layer structure and compositions have been described with examples including Group II-VI materials. In other embodiments, the first submodule 100 of the tandem photovoltaic device 300 can use other photovoltaic materials in alternate layer structures to produce a photovoltaic submodule. In an example, the first submodule 100 can comprise a Group I-III-VI absorber material, such as, for example, copper indium gallium sulfide/selenide (CIGS) or CuInSe₂ (CIS), and can be provided as a thin film. In another example, the first submodule 100 can comprise a perovskite absorber. In a further example, the first submodule 100 can include a silicon absorber, which can comprise amorphous, polycrystalline, crystalline, or thin film silicon.

According to the embodiments provided herein, the p-n junction can be formed by providing the absorber layer 160 sufficiently close to a portion of the first submodule 100 having an excess of negative charge carriers; e.g., electrons or donors. In some embodiments, the absorber layer 160 can be provided adjacent to n-type semiconductor material. Alternatively, one or more intervening layers can be provided between the absorber layer 160 and n-type semiconductor material. In some embodiments, the absorber layer 160 can be provided adjacent to the buffer layer 150. For example, the first surface 162 of the absorber layer 160 can be provided upon the second surface 154 of the buffer layer 150.

The first submodule 100 can include a back contact layer 170 configured to mitigate undesired alteration of the dopant and to provide electrical contact to the absorber layer 160. The back contact layer 170 can have a first surface 172 substantially facing the front side 102 of the first submodule 100 and a second surface 174 substantially facing the back side 104 of the first submodule 100. A thickness of the back contact layer 170 can be defined between the first surface 172 and the second surface 174. The thickness of the back contact layer 170 can be between about 5 nm to about 200 nm such as, for example, between about 10 nm to about 50 nm in one embodiment.

In some embodiments, the back contact layer 170 can be provided adjacent to the absorber layer 160. For example, the first surface 172 of the back contact layer 170 can be provided upon the second surface 164 of the absorber layer 160. In some embodiments, the back contact layer 170 can include combinations of materials from Groups I, II, VI, such as for example, one or more layers containing zinc and tellurium in various compositions. Further suitable materials include, but are not limited to, a bilayer of cadmium zinc telluride and zinc telluride, or zinc telluride doped with a Group V (group 15) dopant such as, for example, nitrogen. A thin film junction 176 can be defined as the thin film stack primarily contributing to the photovoltaic effect. For example, in some embodiments, the thin film junction 176 can include the transparent conductive oxide layer 140, the buffer layer 150, the absorber layer 160, the back contact layer 170, or combinations thereof.

Referring to FIG. 3, the first submodule 100 can include a conducting layer 180, which can be transparent and configured to provide electrical contact with the back contact layer 170, the absorber layer 160, or both. In some embodiments, the conducting layer 180 can be formed towards a back side of the first submodule 100 with respect to the absorber layer 160. In single junction devices, or when provided as a part of a lower or rear submodule (e.g., second submodule 500), the conducting layer 180 can be disposed at the back side of the submodule (e.g., second submodule 500) and can use opaque, non-transparent metal layers as constituents. However, non-transparent layers can be unsuitable for use as the conducting layer 180 of the first submodule 100, disposed between junctions in multi-junction photovoltaic devices or tandem photovoltaic devices. The conducting layer 180 can have a first surface 182 substantially facing the front side 102 of the first submodule 100 and a second surface 184 substantially facing the back side 104 of the first submodule 100. In some embodiments, the conducting layer 180 can be provided adjacent to the back contact layer 170 or the absorber layer 160. For example, the first surface 182 of the conducting layer 180 can be provided upon the second surface 174 of the back contact layer 170 or the second surface 162 of the absorber layer 160. A thickness of the conducting layer 180 can be defined between the first surface 182 and the second surface 184. The thickness of the conducting layer 180 can be less than about 500 nm such as, for example, between about 40 nm and about 400 nm in one embodiment, or between about 60 nm and about 350 nm.

The first submodule 100 can have a back layer 199 at the back side 104 of the first submodule 100. The back surface of the back layer 199 defines the back surface 104 of the front submodule. In some embodiments, the back layer 199 is a region of the conducting layer 180. In some embodiments, the back layer 199 comprises an electron reflector layer. In some embodiments, the back layer 199 comprises a tunnel junction having a p+ subregion and an n+ subregion. In some embodiments, the back layer 199 comprises a tunnel junction having a p++ subregion and an n++ subregion.

Materials such as semiconductors and transparent conductive oxides can be doped with impurities to alter their electrical and optical properties. Dopants can be incorporated into functional layers to modify n-type or p-type charge carrier concentrations. Charge densities of greater than about 1 x 10¹⁶ cm⁻³ can be considered to be "+" type. Although the boundaries are not rigid, a material can be considered n-type if electron donor carriers are present in the range of about 1 x 10¹¹ cm⁻³ to about 1 x 10¹⁶ cm⁻³, and n+ type if donor carrier density is greater than about 1 × 10¹⁶ cm⁻³. Similarly, a material is generally considered p-type if electron acceptor carriers (i.e., "holes") are present in the range of about 1 x 10¹¹ cm⁻³ to about 1 x 10¹⁶ cm⁻³, and p+ type if acceptor carrier density is greater than about 1×10¹⁶ cm⁻³. The boundaries are not rigid and can overlap because a layer can be p+ relative to a layer that is p-type (or n+ relative to a layer that is n-type) if the carrier concentration is at least two orders of magnitude (i.e., 100-fold) higher, regardless of the absolute carrier density. Additionally, charge densities of greater than about 1 x 10¹⁸ cm⁻³ can be considered to be "++" type; and thus a layer of either n-type or p-type can be "++" relative to a layer of the same type that is itself "+" relative to yet a third layer, if the ++ layer has a same-type carrier density more than 100 fold that of the + layer.

Referring now to FIG. 1 and FIG. 5, the tandem photovoltaic device 300 includes a second submodule 500. The second submodule 500 can be disposed below or under the first submodule 100, referencing the front side 302 of the tandem photovoltaic device 300 as the primary light-facing top surface. The photovoltaic device submodule 500 can include a plurality of layers disposed between a first surface 502 on the front side of the second submodule 500 and a second surface on a back side of the second submodule 500. One or more of the plurality of layers can include a photovoltaic absorber material. In some embodiments, the layers of the photovoltaic device submodule 500 can be divided into a plurality of photovoltaic cells.

The second submodule 500 of the tandem photovoltaic device 300 can include one or more absorber materials in a layer structure. In an example, the second submodule 500 can comprise a silicon absorber, which can include amorphous, polycrystalline, crystalline, or thin film silicon. In another example, the second submodule 500 can comprise a perovskite absorber material. In a further example, the second submodule 500 can comprise a Group I-III-VI absorber material, such as CIGS, and can be provided as a thin film. In another example, the second submodule 500 can comprise a Group II-VI absorber material, such as, for example, CdTe, CdZnTe, HgCdTe, or CdSeTe.

The second submodule 500 can share various aspects with the first submodule 100. The second submodule 500 can have a front layer 501 at the front side 502 of the second submodule 500. The front surface of the front layer 501 can define the front surface 502 of the second submodule 500. In some embodiments, the front layer 501 is a buffer layer. In some embodiments, the front layer 501 is a conductive layer. In some embodiments, the front layer 501 includes a conductive metallic grid. In some embodiments, the front layer 501 comprises a transparent conductive oxide. In certain embodiments, a remainder or the entirety of the second submodule 500 can be configured identically or substantially identically to the first submodule 100. Embodiments of the second submodule 500 can include portions that are identical or substantially identical in function and structure to portions of the first submodule 100. In some embodiments, the tandem photovoltaic device 300 includes a second interlayer and back-sheet at the second surface 504 of the second submodule. In some embodiments the second interlayer comprises a material that includes the same matrix polymer as the second conformal layer 430. In some embodiments, the second interlayer is fused to the second conformal layer 430 at a peripheral edge of the device. In some embodiments the back-sheet comprises a material that includes the same material as the core layer 420. In other embodiments the back-sheet comprises glass. In some embodiments the second submodule is substantially encapsulated by a polymer comprising the second conformal layer 430 with electrical connectors, such as bussing wires passing therethrough. Encapsulation of the submodule by the interlayer and second interlayer can contribute to improve robustness of a tandem module.

With continued reference to FIGS. 1 & 5, the tandem photovoltaic device 300 includes an interlayer 400. As shown, the interlayer structure is positioned between the first submodule 100 and the second submodule 500. An example of an interlayer 400 structure is schematically depicted in a cross-section segment in FIG. 6. According to the embodiments provided herein, the interlayer 400 can include a first conformal layer 410 and a core layer 420, where the first conformal layer 410 is disposed between the core layer 420 and the back layer 199 of the first submodule 100. In some embodiments, the core layer 420 can be provided between the first conformal layer 410 and a second conformal layer 430. In some embodiments, the core layer 420 can be provided adjacent to the first conformal layer 410 and adjacent to the second conformal layer 430. For example, the first surface 422 of the core layer 420 can be provided upon the second surface 414 of the first conformal layer 410, and the first surface 432 of the second conformal layer 430 can be provided upon the second surface 424 of the core layer 420. Thus, in some embodiments, the first surface 402 of the interlayer 400 can be formed by the first surface 412 of the first conformal layer 410 and the second surface 402 of the interlayer 400 can be formed by a second surface 434 of the second conformal layer 430.

According to the embodiments provided herein, thickness of the interlayer 400 can be defined between the first surface 402 and the second surface 404. The interlayer 400 thickness can be contiguous and substantially uniform, in certain embodiments, with a thickness deviation across the interlayer 400 of less than 25%. In an example, the thickness of the interlayer 400 can be about 650 microns (650 µm). In some embodiments, the thickness is in a range of 100 µm to 2500 µm, such as, for example, between about 250 µm to 1500 µm, or between about 400 µm to 1000 µm.

In some embodiments, interlayer 400 thickness can be contiguous and irregular. In an example, the core layer is substantially uniform, while one or both of the first and second conformal layers 410, 430, are substantially irregular in thickness. In an example, an interlayer comprises a substantially uniform core layer combined with a substantially irregular conformal layer; this combination confers benefits from the electrical isolation and mechanical strength of the core material combined with the flowability and adhesion of the conformal layers to fill-in and ameliorate surface irregularities of an adjacent module surface. The conformal layer adheres contiguously to directly adjacent surfaces of the submodule and core layer. In some embodiments, a uniform layer deviates from an average thickness by no more than 25%, or in a range of 0% to 25%. In some embodiments, an irregular or non-uniform layer includes thickness deviation of more than 30%, more than 40%, or more than 50% of its average thickness. In some embodiments, an irregular or non-uniform layer includes thickness deviation up to a range of 30% to 100%, a range of 30% to 90%, a range of 40% to 90%, a range of 40% to 80%, or a range of 45% to 75% of the average thickness of the irregular layer.

Certain embodiments of the interlayer 400 can include where an entirety of the interlayer 400 or one or more layers of the interlayer 400 has a refractive index from about 1.2 to about 2.0 (e.g., about 1.6) for light having a wavelength of 800 nm. In some embodiments, at least one of the first conformal layer 410, the second conformal layer 430, and the core layer 420 can have a refractive index from about 1.2 to about 2.0, where certain embodiments include one or more layers having a refractive index of greater than 1.6 for light having a wavelength of 800 nm. In some embodiments, at least one of the first conformal layer 410, the second conformal layer 430, and the core layer 420 can have a refractive index in a range of 1.6 to 2.5 for 800 nm light.

The interlayer 400 can have an average transmittance greater than 20% for light having a wavelength between 800 nm and 1200 nm. Optionally, the interlayer 400 can have an average transmittance greater than about 25% for light having a wavelength 800 nm to 1200 nm such as, for example, greater than about 50% in one embodiment, or greater than about 60% in another embodiment, or greater than about 75% in a further embodiment.

Without being bound to theory, the interlayer 400 provided herein provides synergistic advantages for tandem photovoltaic devices. Providing an interlayer 400 with a core layer 420 between conformal layers 410, 430 confers advantages, both for manufacturability and operation. The core layer 420 can prevent shorting and can provide physical and electrical separation. The conformal layers 410, 430 can provide good contact to the core layer 420 and to the respective submodules 100, 500, which can minimize irregularities, such as voids and bubbles, to provide reliable optical properties between the submodules 100, 500. Additionally, the interlayer 400 encapsulates and prevents intrusion of moisture into the submodules 100, 500, mitigating corrosion, degradation, and decreased performance that can be associated with humid environments.

The core layer 420 of the interlayer 400 can provide a dielectric and physical barrier that resists deformation and a narrowing of the dielectric breakdown distance. The core layer 420 can have a melting point above 200 degrees C. In certain embodiments, the core layer 420 can have a melting point above 250 degrees C, while other embodiments include where the core layer 420 has a melting point in a range of about 225 degrees C to about 550 degrees C. In some embodiments, the core layer 420 can have a dielectric breakthrough strength of greater than 10 kV/mm, greater than 20 kV/mm, greater than 50 kV/mm, in a range of 10 kV/mm to 250 kV/mm, or in a range of 10 kV/mm to 200 kV/mm.

The core layer 420 can comprise a polymer sheet. In certain embodiments, the core layer 420 can have a thickness in a range of 10 µm to 400 µm. In some embodiments, the core layer 420 can have a thickness greater than 15 µm, greater than 20 µm, greater than 30 µm, greater than 40 µm, greater than 50 µm, greater than 60 µm. In some embodiments, the core layer 420 can have a thickness less than 400 µm, less than 300 µm, less than 200 µm, less than 250 µm, less than 200 µm, less than 150 µm, less than 120 µm, less than 100 µm, less than 90 µm, less than 80 µm, or less than 70 µm. In some embodiments, the core layer 420 can have a thickness of about 40 µm to 140 µm. In some embodiments, the material forming the core layer 420 is a thermoplastic polymer resin. In some embodiments, the material forming the core layer 420 can include one or more of: oriented polyethylene terephthalate (OPET), polytetrafluoroethylene (PTFE), polycyclooctene (PCO), or biaxially-oriented polyethylene terephthalate (boPET).

Generally, each of the conformal layers 410, 430 can be formed by a material comprising a flowable polymer with a melting point less than 170 degrees C to conform to system components during lamination with the submodules 100, 500 and operation at higher temperatures. In some embodiments, the conformal layers 410, 430 are formed by a material with a melting point less than 110 degrees C. In some embodiments, one or both of the conformal layers 410, 430 has a melting point in a range of about 50 degrees C to about 170 degrees C, in a range of 70 degrees C to 170 degrees C, in a range of 70 degrees C to 110 degrees C, in a range of 90 degrees C to 140 degrees C, or in a range of 80 degrees C to 110 degrees C. In some embodiments, one or both of the conformal layers 410, 430 has a melting point less than 150 degrees C, less than 130 degrees C, less than 120 degrees C, less than 110 degrees C, or less than 100 degrees C.

Materials for first conformal layer 410 can include polyethylene (PE), ethylene-vinyl acetate (EVA), and/or polyolefin elastomer (POE). Other materials suitable for use in the layer include various optically compatible adhesives.

The thickness of each of the conformal layers 410, 430 can be from about 180 µm to about 740 µm. In some embodiments, the first conformal layer 410 has a thickness greater than 180 µm, greater than 200 µm, greater than 220 µm, greater than 250 µm, or greater than 280 µm. In some embodiments, the first conformal layer 410 has a thickness less than 700 µm, less than 600 µm, less than 500 µm, less than 400 µm, less than 350 µm, or less than 320 µm. In some embodiments, the second conformal layer 430 has a thickness greater than 180 µm, greater than 200 µm, greater than 220 µm, greater than 250 µm, or greater than 280 µm. In some embodiments, the second conformal layer 430 has a thickness less than 700 µm, less than 600 µm, less than 500 µm, less than 400 µm, less than 350 µm, or less than 320 µm.

The conformal layers 410, 430 can be configured to conform to irregularities of an adjoining surface, including surface roughness of either the second surface 104 of the first submodule 100 or the first surface 502 of the second submodule 500, respectively. In some embodiments, a ratio between an average surface roughness of the adjoining surface to the thickness of the respective adjacent conformal layer is between 1:1 and 1:1000. In some embodiments, the ratio between the average surface roughness of the adjoining surface to the thickness of the conformal layer is greater than 1:1, greater than 1:2, greater than 1:10, greater than 1:50, or greater than 1:100. In some embodiments, the ratio between the average surface roughness of the adjoining surface to the thickness of the conformal layer is less than 1:900, less than 1:750, less than 1:500, less than 1:300, or less than 1:200. The flowable composition of the conformal layer at processing temperatures during manufacturing provides beneficial wettability and adhesion despite surface irregularities.

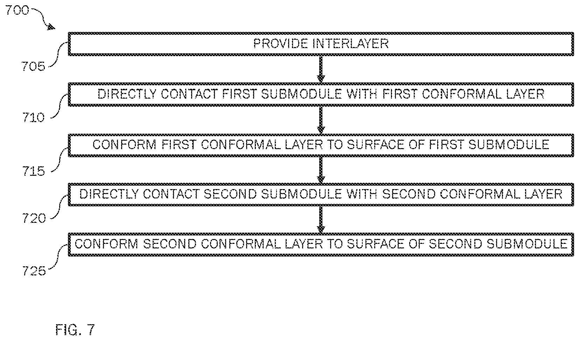

With reference now to FIG. 7, an embodiment of a method of making a tandem photovoltaic device is shown at 700. A first step at 705 can include providing an interlayer 400 as described herein, where the interlayer 400 permits a portion of light to pass therethrough. A second step at 710 can include directly contacting a portion of a surface (e.g., second surface 104) of the first submodule 100 with the first conformal layer 410. A third step at 715 can include conforming the first conformal layer 410 to the portion of the surface (e.g., second surface 104) of the first submodule 100. A fourth step at 720 can include directly contacting a portion of a surface (e.g., first surface 502) of the second submodule 500 with the second conformal layer 430. A fifth step at 725 can include conforming the second conformal layer 500 to the portion of the surface (e.g., first surface 502) of the second submodule 500.

The interlayer 400 can be formed in various ways. In certain embodiments, the core layer 420, the first conformal layer 410, and the second conformal layer 430 can be laminated together in a prebonding step to form the interlayer 400. The core layer 420 can be laminated between the first conformal layer 410 and the second conformal layer 430 to provide the interlayer 400. In certain embodiments, one or more layers of the interlayer are co-extruded as a single sheet or layer. The core layer 420 can be coextruded between the first conformal layer 410 and the second conformal layer 430 to provide the interlayer 400.

Whereas FIG. 7 depicts steps of the method 700 sequentially, it is understood that certain steps can be performed simultaneously and/or certain steps can be performed in a different order than depicted. For example, the first conformal layer 410 can be conformed to the portion of the surface of the first submodule 100 by heating the first conformal layer 410 to at least the melting point of the first polymer. Likewise, the second conformal layer 430 can be conformed to the portion of the surface of the second submodule 500 by heating the second conformal layer 430 to at least the melting point of the second polymer. One of the portion of the surface of the first submodule 100 and the first conformal layer 410 can be heated to at least the melting point of the first polymer prior to directly contacting the portion of the surface of the first submodule 100 with the first conformal layer 410. Likewise, one of the portion of the surface of the second submodule 500 and the second conformal layer 430 can be heated to at least the melting point of the second polymer prior to directly contacting the portion of the surface of the second submodule 500 with the second conformal layer 430. Certain embodiments include where conforming the first conformal layer 410 to the portion of the surface of the first submodule 100 and conforming the second conformal layer 430 to the portion of the surface of the second submodule 500 includes simultaneously heating the first submodule 100, the interlayer 400, and the second submodule 500 to at least the melting point of the first polymer and at least the melting point of the second polymer following directly contacting the portion of the surface of the first submodule 100 with the first conformal layer 410 and directly contacting the portion of the surface of the second submodule 500 with the second conformal layer 430. It is further possible to conform the first conformal layer 410 to the portion of the surface of the first submodule 100 by pressing the interlayer 400 and the first submodule 100 together and to conform the second conformal layer 430 to the portion of the surface of the second submodule 500 by pressing the interlayer 400 and the second submodule 500 together. Conforming the first conformal layer 410 to the portion of the surface of the first submodule 100 and conforming the second conformal layer to the portion of the surface of the second submodule 500 can include pressing the interlayer 400 between the first submodule 100 and the second submodule 500.

In some embodiments, a method of forming a tandem photovoltaic device includes: directly contacting a back or second surface 104 of a first submodule 100 with a first surface 402, 412 of a first conformal layer 410; directly contacting a front or first surface 502 of a second submodule 500 with a second surface 404, 434 of a second conformal layer 430; providing a core layer 420 between the first conformal layer 410 and the second conformal layer 430. The method can comprise conforming the first conformal layer to the surface of the first submodule; and conforming the second conformal layer to the surface of the second submodule.

The method can be performed at a processing temperature below a melt temperature of the core layer. The processing temperature can be near, at, or above a melt temperature of a conformal layer. In some instances, the processing temperature is within 15 degrees C above or below the melt temperature of a first polymer. In some instances, the processing temperature is within 15 degrees C above or below the melt temperature of a second polymer. In some instances, the processing temperature is above the melt temperature of a first and second polymer. In some embodiments of the method of bonding the interlayer to the first and second submodules, the processing temperature is 20 to 150 degrees below the melt temperature of a third polymer comprising the core layer. In some instances, the processing temperature is in a range of 80 to 170 degrees C. In some instances, the processing temperature is less than 150 degrees C, less than 140 degrees C, less than 130 degrees C, less than 120 degrees C, less than 110 degrees C, less than 100 degrees C, less than 90 degrees C, or less than 85 degrees C.

By controlling the thicknesses and composition of the sublayers of the interlayer, material heat capacity and heat transfer during manufacturing can be controlled to prevent damage to temperature-sensitive components of an adjacent module at processing temperatures suitable to meld and adhere the conformal layer to a surface of the adjacent module. During a laminating or bonding process at processing temperatures, the core layer can be a solid, contiguous sheet, while simultaneously, one or both of the conformal layers are heated to a flowable, viscous state. The methods produce a durable interlayer with good adhesion, robust electrical breakthrough strength, and high transparency for near infrared wavelengths.

Example embodiments are provided so that this disclosure will be thorough, and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail.

## Claims

1. A tandem photovoltaic device (300) comprising:
a first submodule (100);
a second submodule (500);
an interlayer (400) disposed between the first submodule (100) and the second submodule (500), wherein the interlayer (400) permits a portion of light to pass therethrough, the interlayer (400) including:
a first conformal layer (410) directly contacting and conforming to a portion of a surface of the first submodule (100), the first conformal layer (410) including a first polymer having a melting point less than 170 degrees C;
a second conformal layer (430) directly contacting and conforming to a portion of a surface of the second submodule (500), the second conformal layer (430) including a second polymer having a melting point less than 170 degrees C;
a core layer (420) disposed between and directly contacting the first conformal layer (410) and the second conformal layer (430), the core layer (420) including a third polymer having a melting point greater than 200 degrees C; **characterized in that**
the first polymer includes a member selected from a group consisting of:
polyethylene; ethylene-vinyl acetate; polyolefin elastomer; and combinations thereof;
the second polymer includes a member selected from a group consisting of:
polyethylene; ethylene-vinyl acetate; polyolefin elastomer; and combinations thereof; and
the third polymer includes a member selected from a group consisting of:
oriented polyethylene terephthalate; polytetrafluoroethylene; polycyclooctene; biaxially-oriented polyethylene terephthalate; polyimide; and combinations thereof.

2. The tandem photovoltaic device (300) of Claim 1, wherein the interlayer (400) has a refractive index in a range of 1.4 to 1.8 at 800 nm.

3. The tandem photovoltaic device (300) of Claim 1 or Claim 2, wherein:
the first polymer has a melting point in a range of 70 degrees C to 120 degrees C;
the second polymer has a melting point in a range of 70 degrees C to 120 degrees C; and
the third polymer has a melting point in a range of 200 degrees C to 300 degrees C.

4. The tandem photovoltaic device (300) of any one of Claims 1-3, wherein the interlayer (400) is configured to transmit at least 90% of light having a wavelength from about 700 nm to about 1300 nm passing therethrough.

5. The tandem photovoltaic device (300) of any one of Claims 1-4, wherein the first polymer and the second polymer comprise the same material.

6. The tandem photovoltaic device (300) of any one of Claims 1-5, wherein the core layer (420) has a thickness in a range of 25 µm to 200 µm.

7. The tandem photovoltaic device (300) of any one of Claims 1-6, wherein the core layer (420) has a dielectric strength greater than about 50 kV/mm.

8. The tandem photovoltaic device (300) of any one of Claims 1-7, wherein the first conformal layer (410) and the second conformal layer (430) have different thicknesses.

9. The tandem photovoltaic device (300) of any one of Claims 1-8, wherein the first conformal layer (410) has a thickness from 180 µm to 740 µm, the second conformal layer (430) has a thickness from 180 µm to 740 µm, the core layer (420) has a thickness from 25 µm to 200 µm, and the third polymer of the core layer includes biaxially-oriented polyethylene terephthalate.

10. A method of making a tandem photovoltaic device (300), comprising:
providing an interlayer (400), wherein the interlayer (400) permits a portion of light to pass therethrough, the interlayer (400) including:
a first conformal layer (410) including a first polymer having a melting point less than 170 degrees C;
a second conformal layer (430) including a second polymer having a melting point less than 170 degrees C;
a core layer (420) disposed between and directly contacting the first conformal layer (410) and the second conformal layer (430), the core layer (420) including a third polymer having a melting point greater than 200 degrees C;
directly contacting a portion of a surface of a first submodule (100) with the first conformal layer (410);
conforming the first conformal layer (410) to the portion of the surface of the first submodule (100);
directly contacting a portion of a surface of a second submodule (500) with the second conformal layer (430); and
conforming the second conformal layer (430) to the portion of the surface of the second submodule (500); **characterized in that**
the first polymer includes a member selected from a group consisting of:
polyethylene; ethylene-vinyl acetate; polyolefin elastomer; and combinations thereof;
the second polymer includes a member selected from a group consisting of:
polyethylene; ethylene-vinyl acetate; polyolefin elastomer; and combinations thereof; and
the third polymer includes a member selected from a group consisting of:
oriented polyethylene terephthalate; polytetrafluoroethylene; polycyclooctene;
biaxially-oriented polyethylene terephthalate; polyimide; and combinations thereof.

11. The method of Claim 10, further comprising laminating the core layer (420) between the first conformal layer (410) and the second conformal layer (430) to provide the interlayer (400).

12. The method of Claim 10, further comprising coextruding the core layer (420) between the first conformal layer (410) and the second conformal layer (430) to provide the interlayer (400).

13. The method of any one of Claims 10-12, wherein:
one of the portion of the surface of the first submodule (100) and the first conformal layer (410) is heated to at least the melting point of the first polymer prior to directly contacting the portion of the surface of the first submodule (100) with the first conformal layer (410); and
one of the portion of the surface of the second submodule (500) and the second conformal layer (430) is heated to at least the melting point of the second polymer prior to directly contacting the portion of the surface of the second submodule (500) with the second conformal layer (430).

14. The method of any one of Claims 10-13, wherein:
conforming the first conformal layer (410) to the portion of the surface of the first submodule (100) includes pressing the interlayer (400) and the first submodule (100) together; or
conforming the second conformal layer (430) to the portion of the surface of the second submodule (500) includes pressing the interlayer (400) and the second submodule (500) together.

15. The method of any one of Claims 10-14, wherein the contacting steps are performed at a processing temperature below 120 degrees C.

## Patentansprüche

1. Tandem-Photovoltaikvorrichtung (300), Folgendes umfassend:
ein erstes Submodul (100);
ein zweites Submodul (500);
eine Zwischenschicht (400), die zwischen dem ersten Submodul (100) und dem zweiten Submodul (500) angeordnet ist, wobei die Zwischenschicht (400) einen Teil von Licht durchlässt, wobei die Zwischenschicht (400) Folgendes beinhaltet:
eine erste konforme Schicht (410), die mit einem Teil einer Oberfläche des ersten Submoduls (100) direkt in Kontakt steht und sich an diesen anpasst, wobei die erste konforme Schicht (410) ein erstes Polymer mit einem Schmelzpunkt von weniger als 170 Grad C beinhaltet;
eine zweite konforme Schicht (430), die mit einem Teil einer Oberfläche des zweiten Submoduls (500) direkt in Kontakt steht und sich an diesen anpasst, wobei die zweite konforme Schicht (430) ein zweites Polymer mit einem Schmelzpunkt von weniger als 170 Grad C beinhaltet;
eine Kernschicht (420), die zwischen der ersten konformen Schicht (410) und der zweiten konformen Schicht (430) angeordnet ist und mit diesen direkt in Kontakt steht, wobei die Kernschicht (420) ein drittes Polymer mit einem Schmelzpunkt größer als 200 Grad C beinhaltet;
**dadurch gekennzeichnet, dass**
das erste Polymer ein Element beinhaltet, ausgewählt aus einer Gruppe, bestehend aus: Polyethylen; Ethylen-Vinylacetat; Polyolefinelastomer; und Kombinationen davon;
das zweite Polymer ein Element beinhaltet, ausgewählt aus einer Gruppe, bestehend aus: Polyethylen; Ethylen-Vinylacetat; Polyolefinelastomer; und Kombinationen davon; und
das dritte Polymer ein Element beinhaltet, ausgewählt aus einer Gruppe, bestehend aus: orientiertem Polyethylenterephthalat; Polytetrafluorethylen; Polycycloocten; biaxial orientiertem Polyethylenterephthalat; Polyimid; und Kombinationen davon.

2. Tandem-Photovoltaikvorrichtung (300) nach Anspruch 1, wobei die Zwischenschicht (400) einen Brechungsindex in einem Bereich von 1,4 bis 1,8 bei 800 nm aufweist.

3. Tandem-Photovoltaikvorrichtung (300) nach Anspruch 1 oder Anspruch **2,** wobei:
das erste Polymer einen Schmelzpunkt in einem Bereich von 70 Grad C bis 120 Grad C aufweist;
das zweite Polymer einen Schmelzpunkt in einem Bereich von 70 Grad C bis 120 Grad C aufweist; und
das dritte Polymer einen Schmelzpunkt in einem Bereich von 200 Grad C bis 300 Grad C aufweist.

4. Tandem-Photovoltaikvorrichtung (300) nach einem der Ansprüche 1-3, wobei die Zwischenschicht (400) dazu konfiguriert ist, wenigstens 90 % von durch sie hindurchtretendem Licht, das eine Wellenlänge von etwa 700 nm bis etwa 1300 nm aufweist, zu transmittieren.

5. Tandem-Photovoltaikvorrichtung (300) nach einem der Ansprüche 1-4, wobei das erste Polymer und das zweite Polymer das gleiche Material umfassen.

6. Tandem-Photovoltaikvorrichtung (300) nach einem der Ansprüche 1-5, wobei die Kernschicht (420) eine Dicke in einem Bereich von 25 µm bis 200 µm aufweist.

7. Tandem-Photovoltaikvorrichtung (300) nach einem der Ansprüche 1-6, wobei die Kernschicht (420) eine Spannungsfestigkeit größer als etwa 50 kV/mm aufweist.

8. Tandem-Photovoltaikvorrichtung (300) nach einem der Ansprüche 1-7, wobei die erste konforme Schicht (410) und die zweite konforme Schicht (430) unterschiedliche Dicken aufweisen.

9. Tandem-Photovoltaikvorrichtung (300) nach einem der Ansprüche 1-8, wobei die erste konforme Schicht (410) eine Dicke von 180 µm bis 740 µm aufweist, die zweite konforme Schicht (430) eine Dicke von 180 µm bis 740 µm aufweist, die Kernschicht (420) eine Dicke von 25 µm bis 200 µm aufweist und das dritte Polymer der Kernschicht biaxial orientiertes Polyethylenterephthalat beinhaltet.

10. Verfahren zum Herstellen einer Tandem-Photovoltaikvorrichtung (300), umfassend:
Bereitstellen einer Zwischenschicht (400), wobei die Zwischenschicht (400) einen Teil von Licht durchlässt, wobei die Zwischenschicht (400) Folgendes beinhaltet:
eine erste konforme Schicht (410), die ein erstes Polymer mit einem Schmelzpunkt von weniger als 170 Grad C beinhaltet;
eine zweite konforme Schicht (430), die ein zweites Polymer mit einem Schmelzpunkt von weniger als 170 Grad C beinhaltet;
eine Kernschicht (420), die zwischen der ersten konformen Schicht (410) und der zweiten konformen Schicht (430) angeordnet ist und mit diesen direkt in Kontakt steht, wobei die Kernschicht (420) ein drittes Polymer mit einem Schmelzpunkt größer als 200 Grad C beinhaltet;
direktes Inkontaktbringen eines Teils einer Oberfläche eines ersten Submoduls (100) mit der ersten konformen Schicht (410);
Anpassen der ersten konformen Schicht (410) an den Teil der Oberfläche des ersten Submoduls (100);
direktes Inkontaktbringen eines Teils einer Oberfläche eines zweiten Submoduls (500) mit der zweiten konformen Schicht (430); und
Anpassen der zweiten konformen Schicht (430) an den Teil der Oberfläche des zweiten Submoduls (500); **dadurch gekennzeichnet, dass**
das erste Polymer ein Element beinhaltet, ausgewählt aus einer Gruppe, bestehend aus:
Polyethylen; Ethylen-Vinylacetat; Polyolefinelastomer; und Kombinationen davon;
das zweite Polymer ein Element beinhaltet, ausgewählt aus einer Gruppe, bestehend aus:
Polyethylen; Ethylen-Vinylacetat; Polyolefinelastomer; und Kombinationen davon; und
das dritte Polymer ein Element beinhaltet, ausgewählt aus einer Gruppe, bestehend aus:
orientiertem Polyethylenterephthalat; Polytetrafluorethylen; Polycycloocten; biaxial orientiertem Polyethylenterephthalat; Polyimid; und Kombinationen davon.

11. Verfahren nach Anspruch 10, ferner umfassend Laminieren der Kernschicht (420) zwischen der ersten konformen Schicht (410) und der zweiten konformen Schicht (430), um die Zwischenschicht (400) bereitzustellen.

12. Verfahren nach Anspruch 10, ferner umfassend Koextrudieren der Kernschicht (420) zwischen der ersten konformen Schicht (410) und der zweiten konformen Schicht (430), um die Zwischenschicht (400) bereitzustellen.

13. Verfahren nach einem der Ansprüche 10-12, wobei:
eines von dem Teil der Oberfläche des ersten Submoduls (100) und der ersten konformen Schicht (410) auf mindestens den Schmelzpunkt des ersten Polymers erwärmt wird, bevor der Teil der Oberfläche des ersten Submoduls (100) mit der ersten konformen Schicht (410) direkt in Kontakt gebracht wird; und
eines von dem Teil der Oberfläche des zweiten Submoduls (500) und der zweiten konformen Schicht (430) auf mindestens den Schmelzpunkt des zweiten Polymers erwärmt wird, bevor der Bereich der Oberfläche des zweiten Submoduls (500) mit der zweiten konformen Schicht (430) direkt in Kontakt gebracht wird.

14. Verfahren nach einem der Ansprüche 10-13, wobei:
Anpassen der ersten konformen Schicht (410) an den Teil der Oberfläche des ersten Submoduls (100) Zusammendrücken der Zwischenschicht (400) und des ersten Submoduls (100) beinhaltet; oder
Anpassen der zweiten konformen Schicht (430) an den Teil der Oberfläche des zweiten Submoduls (500) Zusammendrücken der Zwischenschicht (400) und des zweiten Submoduls (500) beinhaltet.

15. Verfahren nach einem der Ansprüche 10-14, wobei die Schritte des Inkontaktbringens bei einer Verarbeitungstemperatur unterhalb 120 Grad C durchgeführt werden.

## Revendications

1. Dispositif photovoltaïque en tandem (300) comprenant :
un premier sous-module (100) ;
un second sous-module (500) ;
une couche intermédiaire (400) disposée entre le premier sous-module (100) et le second sous-module (500), dans lequel la couche intermédiaire (400) permet à une partie de la lumière de passer à travers celle-ci, la couche intermédiaire (400) comportant :
une première couche conforme (410) en contact direct avec et conforme à une partie d'une surface du premier sous-module (100), la première couche conforme (410) comportant un premier polymère ayant un point de fusion inférieur à 170 degrés C ;
une seconde couche conforme (430) en contact direct avec et conforme à une partie d'une surface du second sous-module (500), la seconde couche conforme (430) comportant un deuxième polymère ayant un point de fusion inférieur à 170 degrés C ;
une couche centrale (420) disposée entre et en contact direct avec la première couche conforme (410) et la seconde couche conforme (430), la couche centrale (420) comportant un troisième polymère ayant un point de fusion supérieur à 200 degrés C ;
**caractérisé en ce que**
le premier polymère comporte un élément sélectionné dans un groupe constitué de : polyéthylène ; éthylène-acétate de vinyle ; élastomère de polyoléfine ; et des combinaisons de ceux-ci ;
le deuxième polymère comporte un élément sélectionné dans un groupe constitué de : polyéthylène ; éthylène-acétate de vinyle ; élastomère de polyoléfine ; et des combinaisons de ceux-ci ; et
le troisième polymère comporte un élément sélectionné dans un groupe constitué de : polyéthylène téréphtalate orienté ; polytétrafluoroéthylène ; polycyclooctène ; polyéthylène téréphtalate à orientation biaxiale ; polyimide ; et des combinaisons de ceux-ci.

2. Dispositif photovoltaïque en tandem (300) selon la revendication 1, dans lequel la couche intermédiaire (400) a un indice de réfraction compris dans une plage allant de 1,4 à 1,8 à 800 nm.

3. Dispositif photovoltaïque en tandem (300) selon la revendication 1 ou la revendication 2, dans lequel :
le premier polymère a un point de fusion compris dans une plage allant de 70 degrés C à 120 degrés C ;
le deuxième polymère a un point de fusion compris dans une plage allant de 70 degrés C à 120 degrés C ; et
le troisième polymère a un point de fusion compris dans une plage allant de 200 degrés C à 300 degrés C.

4. Dispositif photovoltaïque en tandem (300) selon l'une quelconque des revendications 1 à 3, dans lequel la couche intermédiaire (400) est configurée pour transmettre au moins 90 % de la lumière ayant une longueur d'onde d'environ 700 nm à environ 1 300 nm passant à travers celle-ci.

5. Dispositif photovoltaïque en tandem (300) selon l'une quelconque des revendications 1 à 4, dans lequel le premier polymère et le deuxième polymère comprennent le même matériau.

6. Dispositif photovoltaïque en tandem (300) selon l'une quelconque des revendications 1-5, dans lequel la couche centrale (420) a une épaisseur comprise dans une plage allant de 25 µm à 200 µm.

7. Dispositif photovoltaïque en tandem (300) selon l'une quelconque des revendications 1 à 6, dans lequel la couche centrale (420) a une rigidité diélectrique supérieure à environ 50 kV/mm.

8. Dispositif photovoltaïque en tandem (300) selon l'une quelconque des revendications 1-7, dans lequel la première couche conforme (410) et la seconde couche conforme (430) ont des épaisseurs différentes.

9. Dispositif photovoltaïque en tandem (300) selon l'une quelconque des revendications 1 à 8, dans lequel la première couche conforme (410) a une épaisseur de 180 µm à 740 µm, la seconde couche conforme (430) a une épaisseur de 180 µm à 740 µm, la couche centrale (420) a une épaisseur de 25 µm à 200 µm, et le troisième polymère de la couche centrale comporte du polyéthylène téréphtalate à orientation biaxiale.

10. Procédé de fabrication d'un dispositif photovoltaïque en tandem (300), comprenant :
la fourniture d'une couche intermédiaire (400), dans lequel la couche intermédiaire (400) permet à une partie de la lumière de passer à travers celle-ci, la couche intermédiaire (400) comportant :
une première couche conforme (410) comportant un premier polymère ayant un point de fusion inférieur à 170 degrés C ;
une seconde couche conforme (430) comportant un deuxième polymère ayant un point de fusion inférieur à 170 degrés C ;
une couche centrale (420) disposée entre et en contact direct avec la première couche conforme (410) et la seconde couche conforme (430), la couche centrale (420) comportant un troisième polymère ayant un point de fusion supérieur à 200 degrés C ;
la mise en contact direct d'une partie d'une surface d'un premier sous-module (100) avec la première couche conforme (410) ;
la conformation de la première couche conforme (410) à la partie de la surface du premier sous-module (100) ;
la mise en contact direct d'une partie d'une surface d'un second sous-module (500) avec la seconde couche conforme (430) ; et
la conformation de la seconde couche conforme (430) à la partie de la surface du second sous-module (500) ; **caractérisé en ce que**
le premier polymère comporte un élément sélectionné dans un groupe constitué de :
polyéthylène ; éthylène-acétate de vinyle ; élastomère de polyoléfine ; et des combinaisons de ceux-ci ;
le deuxième polymère comporte un élément sélectionné dans un groupe constitué de :
polyéthylène ; éthylène-acétate de vinyle ; élastomère de polyoléfine ; et des combinaisons de ceux-ci ; et
le troisième polymère comporte un élément sélectionné dans un groupe constitué de :
polyéthylène téréphtalate orienté ; polytétrafluoroéthylène ; polycyclooctène ; polyéthylène téréphtalate à orientation biaxiale ; polyimide ; et des combinaisons de ceux-ci.

11. Procédé selon la revendication 10, comprenant en outre la stratification de la couche centrale (420) entre la première couche conforme (410) et la seconde couche conforme (430) afin de fournir la couche intermédiaire (400).

12. Procédé selon la revendication 10, comprenant en outre la coextrusion de la couche centrale (420) entre la première couche conforme (410) et la seconde couche conforme (430) afin de fournir la couche intermédiaire (400).

13. Procédé selon l'une quelconque des revendications 10 à 12, dans lequel :
l'une de la partie de la surface du premier sous-module (100) et de la première couche conforme (410) est chauffée au moins jusqu'au point de fusion du premier polymère avant de mettre directement en contact la partie de la surface du premier sous-module (100) avec la première couche conforme (410) ; et
l'une de la partie de la surface du second sous-module (500) et de la seconde couche conforme (430) est chauffée au moins jusqu'au point de fusion du deuxième polymère avant de mettre directement en contact la partie de la surface du second sous-module (500) avec la seconde couche conforme (430).

14. Procédé selon l'une quelconque des revendications 10 à 13, dans lequel :
la conformation de la première couche conforme (410) à la partie de la surface du premier sous-module (100) comporte le pressage de la couche intermédiaire (400) et du premier sous-module (100) l'un contre l'autre ; ou
la conformation de la seconde couche conforme (430) à la partie de la surface du second sous-module (500) comporte le pressage de la couche intermédiaire (400) et du second sous-module (500) l'un contre l'autre.

15. Procédé selon l'une quelconque des revendications 10 à 14, dans lequel les étapes de mise en contact sont effectuées à une température de traitement inférieure à 120 degrés **C.**
